# EUROPÄISCHE PATENTSCHRIFT

(11) **EP 3 284 325 B1**
(45) Veröffentlichungstag und Bekanntmachung des Hinweises auf die Patenterteilung: **04.10.2023**
(21) Anmeldenummer: 16726418.3
(22) Anmeldetag: 13.04.2016
(51) Int. Cl.: H05K 3/04, B41J 2/44, H05K 3/10

(54) **VORRICHTUNG UND VERFAHREN ZUR HERSTELLUNG VON LEITERPLATTEN FÜR ELEKTRISCHE UND/ODER ELEKTRONISCHE SCHALTUNGEN**
DEVICE AND METHOD FOR PRODUCING PRINTED CIRCUIT BOARDS FOR ELECTRICAL AND/OR ELECTRONIC CIRCUITS
DISPOSITIF ET PROCÉDÉ DE PRODUCTION DE CIRCUITS IMPRIMÉS POUR CIRCUITS ÉLECTRIQUES ET/OU ÉLECTRONIQUES

(30) Priorität: 13.04.2015 DE 102015004508
(43) Veröffentlichungstag der Anmeldung: 21.02.2018
(73) Patentinhaber: Franck, Jan, 95466 Weidenberg (DE)
(72) Erfinder: Franck, Jan, 95466 Weidenberg (DE)
(74) Vertreter: Küchler, Stefan
(86) Internationale Anmeldenummer: PCT/IB2016/000465
(87) Internationale Veröffentlichungsnummer: WO 2016/166590

(56) Entgegenhaltungen:
- DE-A1- 10 347 035
- DE-T2- 69 927 693
- KR-B1- 101 046 255
- US-A- 5 826 329
- US-A- 5 932 280
- US-A1- 2006 263 725
- US-A1- 2008 057 233
- US-B1- 6 233 001

## Beschreibung

Die Erfindung richtet sich auf eine Verfahren zur Herstellung von Leiterplatten für elektrische und elektronische Schaltungen, mit einem elektrisch nicht leitenden Substrat und darauf applizierten, elektrisch leitenden Bahnen, sowie auf eine Vorrichtung zur Herstellung von Leiterplatten für elektrische und elektronische Schaltungen, mit einem elektrisch nicht leitenden Substrat und darauf applizierten, elektrisch leitenden Bahnen.

Üblicherweise werden Leiterplatten für Elektronikschaltungen aus einem mit Kupfer beschichteten Subtrat hergestellt, indem das Kupfer weggeätzt wird, nachdem die gewünschten Leiterbahnen auf die Kupferschicht übertragen und diese dadurch selektiv versiegelt wurden, so dass unter den versiegelten Bereichen das Kupfer nicht abgetragen wird. Dieses Verfahren ist jedoch vergleichsweise zeitaufwändig, da der Ätzvorgang nur mit einer begrenzten Geschwindigkeit abläuft.

KR 101 046 255 B1 offenbart ein Verfahren zur Herstellung von Leiterplatten wobei elektrisch leitenden Bahnen entsprechend einem gewünschten Leiterbahn-Layout unter Einwirkung von Hitze auf eine Kupferschicht, die auf einem folienartigen Träger appliziert ist, auf einem Substrat aufgedruckt werden.

Aus den Nachteilen des beschriebenen Standes der Technik resultiert das die Erfindung initiierende Problem, ein Verfahren und eine Vorrichtung zur Herstellung von Leiterbahnen für elektrische und/oder elektronische Schaltungen derart weiterzubilden, dass die Herstellung möglichst schnell und ohne längere Bearbeitunsgzeiten erfolgen kann.

Die Lösung dieses Problems gelingt bei einem gattungsgemäßen Verfahren dadurch, dass die elektrisch leitenden Bahnen entsprechend dem gewünschten Leiterbahn-Layout unter Einwirkung von Hitze auf ein elektrisch leitfähiges Druckmedium auf das Substrat übertragen, d.h. aufgedruckt werden.

Die Erfindung betrifft ein Verfahren nach Anspruch 1, und geht dabei - anders als beim Stand der Technik - nicht von einem auf der Leiterbahnseite mit Kupfer beschichteten Substrat aus, sondern von einem blanken, elektrisch nicht leitenden Substrat. Darauf wird das Muster der Leiterbahnen entsprechend dem gewünschten Leiterbahn-Layout selektiv aufgedruckt. Dabei wird ein elektrisch leitendes Druckmedium verwendet, beispielsweise eine Silber enthaltende Masse. Diese Masse bzw. dieses Druckmedium wird jedoch nicht durch einen Druckkopf gepresst oder mittels eines Rakels aufgetragen od. dgl., sondern befindet sich in flächig verteiltem Zustand auf einer Folie od. dgl. Trägermaterial, welches über dem zu bedruckenden Substrat ausgebreitet wird. Durch selektives Erhitzen einzelner Partien der flächig verteilten Druckmasse wird diese sodann auf das unmittelbar darunter bzw. daneben befindliche Substrat übertragen und verfestigt sich dort wieder in genau dem gewünschten Muster. Hierbei wird ein Druckkopf verwendet, der nur mit einzelnen, näherungsweise punktförmigen Heizelementen versehen ist, welche vorzugsweise in einer Reihe nebeneinander angeordnet sind. Der Druckkopf kommt dabei mit der aufzudruckenden Masse nicht unmittelbar in Kontakt, weil sich dazwischen noch das die Druckmasse aufweisende Trägermaterial befindet. Aus diesem Grunde können große Mengen an Leiterplatten bedruckt werden, ohne dass der Druckkopf dabei verschleißt oder auch nur verschmutzt wird.

Neben bzw. alternativ zu Silber als elektrisch leitfähiger Komponente des Druckmediums können auch andere Materialien Verwendung finden, insbesondere Metalle wie Aluminium, welches bei einem moderaten Schmelzpunkt eine gute elektrische Leitfähigkeit hat, ferner Zink oder Zinn. All diese Metalle haben Schmelzpunkte deutlich unterhalb von 1.000 °C und können daher noch leichter auf ihren Schmelzpunkt erhitzt werden als bspw. Silber. Das elektrisch leitfähige Material könnte in Form von Nanopartikeln auf die Trägerfolie appliziert werden. Die Erfindung bevorzugt jedoch die Bedampfung der Trägerfolie mit dem betreffenden Metall. Dies ist natürlich auch mit höher schmelzenden Materialien wie Silber oder Kupfer möglich. Zum Schutz vor Oxidation können unedle, aufgedampfte Metalle von einer Abdeckfolie versiegelt sein, welche das auf die Trägerfolie aufgedampfte Metall auf dessen zunächst noch freier Seite abdeckt.

Als elektrisch leitfähiger Bestandteil in dem Druckmedium weiterhin verwendbar sind grundsätzlich alle Metalle und Metalllegierungen, bspw. solche Substanzen mit einem Schmelzpunkt von 1.800 °C oder darunter, vorzugsweise mit einem Schmelzpunkt von 1.500 °C oder darunter, weiter bevorzugt mit einem Schmelzpunkt von 1.200 °C oder darunter, insbesondere mit einem Schmelzpunkt von 1.000 °C oder darunter.

Dieses elektrisch leitfähige Material kann als ein Bestandteil in dem Druckmedium aufgenommen sein, welches sodann zusätzliche, vorzugsweise niedriger schmelzende Bestandteile umfasst, bspw. Bindemittel, Weichmacher, etc. Es ist aber auch denkbar, eine solche elektrisch leitfähige Substanz in reiner Form auf ein folienförmiges Trägersubstrat aufzudampfen oder auf adhäsive Weise daran festzulegen, insbesondere in Form von Nanopartikeln, und ggf. mit einer weiteren, bei einer niedrigeren Temperatur als die Nanopartikel schmelzenden Folie abzudecken.

Jedoch sollte das betreffende Material auch punktuell von einem Druckkopf schmelzbar sein. Jener Vorgang ist um so leichter durchführbar, je niedriger der Schmelzpunkt des betreffenden Materials ist. Insofern stellt Aluminium mit einem Schmelzpunkt von 660 °C und einer elektrischen Leitfähigkeit von 35 m/Ohm*mm² einen guten Kompromiss dar. Zink hat nur einen Schmelzpunkt von 419 °C bei einer elektrischen Leitfähigkeit von 16,9 m/Ohm*mm²; bei Zinn liegt der Schmelzpunkt sogar bei nur 232 °C, und die elektrische Leitfähigkeit beträgt immer noch 8,7 m/Ohm*mm².

Während für Zinn oder Zink also herkömmliche Thermo-Druckköpfe Verwendung finden können, sollten für Metalle mit höheren Schmelzpunkten wie Aluminium oder Silber heissere Spezial-Thermo-Druckköpfe eingesetzt werden. Dabei wäre es auch denkbar, anstelle von Heizwiderständen zur Erzeugung lokaler Hitze-Spots auch bspw. Laserstrahlen zu verwenden, welche mittels optischer Hilfsmittel wie bspw. Lichtleitfasern in einem Druckkopf zu den einzelnen Druck-Spots gelenkt werden. Laserstrahlen lassen sich auch sehr schnell ein- und ausschalten und können sehr präzise auf einzelne Spots fokussiert werden, so dass die für höhere Schmelzpunkte benötigte Energiedichte nahezu mühelos erzeugt werden kann.

Das elektrisch leitfähige Druckmedium mittels eines Thermo-Druckkopfs zu erhitzen, hat den Vorteil einer sehr hohen Kontrastschärfe, so dass sich Leiterbahnen mit extrem scharfen Kanten zuverlässig herstellen lassen. Im Gegensatz zu "kalten" Druckverfahren wie bspw. Tintenstrahldruckern werden die einzelnen Metallpartikel dabei zu einer gemeinsamen Matrix verschmolzen und bilden tatsächlich einen einheitlichen Leiter ohne Übergangswiderstände, während bei dem reinen Aufdrucken von Nanopartikeln die Gesamt-Leitfähigkeit nach wie vor von den Übergangswiderständen an den Kontaktstellen abhängt, sowie insbesondere auch davon, ob es überhaupt genug Kontaktstellen gibt.

Es gehört nicht zur Erfindung, bei einer Temperatur unterhalb der Schmelztemperatur zu arbeiten und die einzelnen Metallpartikel nur miteinander zu versintern, also oberflächlich anzuschmelzen, bis sie punktuell zusammenfließen. Hierzu sind zumeist Temperaturen ausreichend, welche um 10 bis 20 % unterhalb des Schmelzpunktes des betreffenden Materials liegen, also bei Aluminium bspw. nur bei 528 °C bis 594 °C. Es kann also auch genügen, den Thermo-Druckkopf nur für Temperaturen zwischen 80 % und 90 % der Schmelztemperatur auszulegen.

Um den Druckkopf weiter zu entlasten, kann vorgesehen sein, dass das zu bedruckende Substrat auf eine Temperatur knapp unterhalb der benötigten Temperatur, also der Schmelztemperatur, vorgeheizt wird, so dass von dem Druckkopf selbst nur die dann noch verbleibende Temperaturdifferenz überwunden werden muss. Am sichersten sollte die Vorheiztemperatur unterhalb der Sintertempeatur liegen, damit keinesfalls schon ein unerwünschtes Sintern vor dem eigentlichen Druckvorgang einsetzt. Für den Thermo-Druckkopf besteht dann die Aufgabe darin, die auf eine Temperatur knapp unterhalb der Sintertemperatur (also bspw. auf 70 % der Schmelztemperatur) vorgewärmte Metallschicht lokal bis über die Schmelztemperatur zu erhitzen also bspw. auf 110 % der Schmelztemperatur. Dieser Differenzbetrag liegt dann in der Größenordnung von etwa 40 % der Schmelztemperatur. Solchenfalls könnte auch Silber mit seinem typischen Schmelzpunkt von 960 °C mit einem Druckkopf verarbeitet werden, dessen Heizleistung nur bei etwa 384 °C bis 400 °C liegt, was ohne weiteres mit Widerstands-Heizelementen erreicht werden kann, solange der gesamte Druckkopf für eine Dauer-Betriebstemperatur ausgelegt ist, welche dem Schmelzpunkt des zu verarbeitenden Metalls entspricht oder etwas größer als jener ist, bspw. bei 110 % des Schmelzpunktes liegt. Heizdrähte oder Wendeln aus Wolfram bspw. haben einen Schmelzpunkt von 3.380 °C und können daher Temperaturen von 1.000 °C locker ertragen. Als Material für das Chassis eines Druckkopfs könnte bspw. ein Keramikwerkstoff mit einer ausreichenden Temperaturbeständigkeit verwendet werden.

Für diese Methode kann es ferner vorteilhaft sein, wenn die metallisierte Seite der Trägerfolie bereits vor dem eigentlichen Druckvorgang in innigen Kontakt mit dem zu bedruckenden Substrat gebracht wird, so dass die dünne Metallschicht entsprechend vorgeheizt wird. Dies könnte nötigenfalls durch eine Andrückwalze erreicht werden.

Ggf. kann zu diesem Zweck das zu bedruckende Substrat zuvor durch einen Ofen transportiert werden. Andererseits könnte auch die zu bedruckende Oberfläche einer Hitzestrahlung ausgesetzt werden, bspw. Infrarot-Strahlung oder Mikrowellenstrahlung.

Die Trägerfolie für die Metallbeschichtung selbst sollte zumindest für die Vorwärmtemperatur bzw. für die Sintertemperatur des Metalles ausgelegt sein, damit sie nicht vor dem Druckvorgang ihre Strukturstabilität verliert. Geeignet wären je nach dem zu verwendenden Metall Folien aus Polytetrafluorethylen (Teflon) oder glatte Carbonfolien, oder sog. ultradünnes Glas. Erfindungsgemäß ist der folienartige Träger eine Carbonfolie oder ein Glasfilm, und wird von einer Vorratsspule entlang des zu bedruckenden Substrats auf eine Ablagespule umgespult.

Carbonfolien sollten unter einem Schutzgas verarbeitet werden, da Sauerstoffzufuhr zu einer Erweichung des Carbons führen kann.

Bei ultradünnem Glas handelt es sich um einen Glas-Film mit einer Stärke in einer Größenordnung von nur 20 µm bis 100 µm, typischerweise etwa 50 µm. Dank seiner geringen Stärke ist ein solches Glas sehr flexibel. Es hat den weiteren Vorteil, dass es transparent ist und also die Wärmestrahlung eines Thermo-Druckkopfs ungehindert passieren lässt. Quarzgläser mit einem hohen SiO₂-Anteil - bspw. 70 Gew.-% SiO₂ oder mehr, vorzugsweise 80 Gew.-% SiO₂ oder mehr, insbesondere 90 Gew.-% SiO₂ oder mehr - sind bis zu Temperaturen von 1.500 °C thermisch stabil.

Mit einer solchen Folie aus einem ultradünnen Glas mit hohem SiO₂-Anteil kann auch Silber auf ein Substrat aufgeschmolzen werden, ohne dass die Folie dadurch beeinträchtigt wird. Sie wird nach dem Druckvorgang unbeschädigt auf einer Ablegespule wieder aufgewickelt.

Bei einer maximalen Temperatur unterhalb der Sintertemperatur zu arbeiten, gehört nicht zur Erfindung. In diesem Fall schmelzen die einzelnen Metallpartikel nicht zu einer einheitlichen Matrix zusammen, es verbleiben daher Übergangswiderstände an den Kontakten zwischen benachbarten Metallpartikeln. Bei dieser Verfahrensweise sollte dann jedoch zwischen der Trägerfolie und den darauf applizierten Metallpartikeln eine niedrig schmelzende Haftfolie verwendet werden, die sich unter dem Einfluss des Thermo-Druckkopfs auflöst, also schmilzt oder sublimiert, und sodann die zuvor festgehaltenen Metallpartikel freisetzt, die sich dann auf dem Substrat niederschlagen können. Es gehört nicht zur Erfindung, dass die Trägerfolie selbst einen entsprechend niedrigen Schmelzpunkt aufweisen. Dabei müsste darauf geachtet werden, dass die Folie sich nicht völlig auflöst, sondern zumindest bereichsweise erhalten bleibt und also wenigstens in Teilen auf die Ablagespule umgespult werden kann.

Weiterhin bietet die Erfindung die Möglichkeit, dass zusätzlich elektrisch nicht leitende Schichten in Form eines elektrisch nicht leitenden Druckmediums auf das Substrat aufgedruckt werden, insbesondere auch unter Hitzeeinwirkung auf das nicht leitende Druckmedium. Damit lassen sich mit ein und derselben Anordnung die Leiterbahnen auch bereits versiegeln.

Hierfür wäre es dann empfehlenswert, als nichtleitende Schicht ein Material mit einem relativ hohen Schmelzpunkt zu verwenden, bspw. eine Folie aus Polytetrafluorethylen (Teflon) oder das oben bereits erwähnte ultradünne Glas, hierbei jedoch bevorzugt eine Sorte mit einem reduzierten SiO₂-Anteil und also einem niedrigeren Schmelzpunkt, der im Verarbeitungsbereich der Thermo-Druckvorrichtung liegt, also vorzugsweise bei dem oder unterhalb des Schmelzpunkt(es) des darunter applizierten Metalles.

Auf eine solchermaßen versiegelte, unterste Leiterbahnebene kann ggf. eine zweite Ebene aufgedruckt werden, wahlweise mit dem selben Metall wie in der ersten Lage oder mit einem Material, das einen niedrigeren Schmelzpunkt aufweist als die elektrisch nicht leitende Siegelschicht.

Darauf lässt sich ggf. wieder eine isolierende Schicht applizieren, und bei Bedarf noch weitere Leiterbahnebenen, jeweils durch nicht leitende Schichten bereichsweise voneinander getrennt. Es sollte allerdings darauf geachtet werden, dass die Schmelzpunkte neu aufgedruckter Schichten möglichst nicht merklich oberhalb des Schmelzpunktes der darunter liegenden Schicht liegen, oder ggf. sogar bei einer niedrigeren Temperatur. Bei gleicher Schmelztemperatur kann ggf. durch einen raschen Zeitablauf ein Durchschmelzen darunter liegender Schichten vermieden werden. Außerdem können elektrische und/oder elektronische Bauteile ebenfalls auf das Substrat aufgedruckt werden, beispielsweise Widerstände, Spannungsteiler, etc. mittels eines widerstandsbehafteten Druckmediums, Kondensatoren durch Aufeinanderschichten einer unteren Schicht aus einem elektrisch leitenden Druckmedium, einer mittleren Schicht aus einem nicht leitenden, beispielsweise dielektrischen Druckmedium, und einer oberen Schicht aus einem elektrisch leitenden Druckmedium, etc. Spulen können als Spiralen ebenfalls aufgedruckt werden, ggf. auch Bauteile mit anderen Eigenschaften wie Heiß- oder Kaltleiter oder auch (elektro-) luminiszierende Elemente.

Als Leiterplatten-Substrat kommt Hartpapier in Betracht, welches der Materialkennung FR2 entspricht; FR bedeutet dabei feuerhemmend (fire retardant). Ferner gelangen mit einem Harz, bspw. mit Epoxidharz, getränkte Matten, insbesondere Glasfasermatten, zum Einsatz, welche der Materialkennung FR4 entsprechen. FR4-Materialien haben eine bessere Kriechstromfestigkeit und bessere Hochfrequenzeigenschaften sowie eine geringere Wasseraufnahme als Hartpapier.

Für Spezialanwendungen steht auch ein Leiterplatten-Substrat mit anderen Werkstoffen als Basismaterial zur Verfügung. Zu nennen sind in diesem Zusammenhang vor allem Teflon, aber auch Aluminiumoxid oder Keramik, insbesondere in Form von Niedertemperatur-Einbrand-Keramik (LTCC, lowtemperature cofired ceramics) und/oder Hochtemperatur-Mehrlagen-Keramik (HTCC, high temperature cofired ceramics), insbesondere auch für die Anwendungen in der Hochfrequenztechnik. Aus den vorgenannten Materialien werden starre Leiterplatten-Substrate produziert, welche also kaum bis gar nicht biegsam sind.

Als flexible Leiterplatten-Substrate bieten sich dagegen Folien an, insbesondere Polyesterfolie.

Leiterplatten-Substrate mit erhöhten Anforderungen hinsichtlich der Kühlung bzw. Wärmeabführung können einen oder mehrere Kerne aus einem Metall wie Aluminium oder Kupfer aufweisen, oder aus einer Metalllegierung.

Ferner betrifft die Erfindung eine Vorrichtung nach Anspruch 5 zur Herstellung von Leiterplatten für elektrische und elektronische Schaltungen, mit einem elektrisch nicht leitenden Substrat und darauf applizierten, elektrisch leitenden Bahnen, umfassend einen Druckkopf zur selektiven Erhitzung eines elektrisch leitfähigen Druckmediums entsprechend dem gewünchten Leiterbahn-Layout, um dieses Druckmedium auf das Substrat zu übertragen. Diese umfasst einerseits eine Vorrichtung zum Bereithalten einer mit dem Druckmedium belegten Folie, bspw. aufgewickelt um einen Kern, und um diese mit dem Druckmedium belegten Folie von dort abzuspulen und auf oder an dem Substrat auf- oder anzulegen, sowie andererseits eine Druckvorrichtung in Form eines Thermodruckkopfs mit einer Vielzahl von unabhängig voneinander erhitzbaren Miniatur-Elementen, welche jeweils einen kleinen Bereich des Druckmediums auf der Folie erhitzen und dadurch das erhitzte Druckmedium auf das elektrisch nicht leitende Substrat übertragen, um dort eine Leiterbahn od. dgl. zu erzeugen. Erfindungsgemäß ist der folienartige Träger eine Carbonfolie oder ein Glasfilm.

Bevorzugt kann dabei das zu bedruckende, elektrisch nicht leitende Substrat an der Druckeinrichtung vorbei transportiert werden. Das folienartige Trägermaterial mit dem zunächst daran flächig applizierten Druckmedium kann mit einer vergleichbaren Geschwindigkeit parallel zu dem zu bedruckenden Substrat transportiert werden, während der Druckkopf eher stillsteht oder sich nur quer zur Transportrichtung bewegt. Erfindungsgemäß wird das flächige Trägermaterial zwischen zwei Spulen umgespult, also von einer Vorratsspule auf eine Ablagespule, von oder mit der es dann entsorgt oder wiederverwertet werden kann.

Dabei können in Transportrichtung des Substrats hintereinander mehrere Druckeinrichtungen vorgesehen sein, jeweils mit einem Druckkopf und mit je einer Vorrats- und Ablagespule für eine Folie mit einem spezifischen Druckmedium, also mit einem elektrisch leitenden Druckmedium oder mit einem elektrisch nicht leitenden Druckmedium, mit einem dielektrischen Druckmedium oder mit einem (elektro-) luminiszierenden Druckmedium, etc.

Durch Über- und Nebeinanderdrucken dieser verschiedenen Druckmedien kann jede Leiterplatte mit einem beliebigen Leiterbahn-Layout drucktechnisch hergestellt werden, ggf. sogleich mit verschiedenen Bauteilen wie Spulen, Kondensatoren, Widerständen, etc. Sofern diskrete Bauteile wie Transistoren, Mikroprozessoren oder Steckkontakte noch erforderlich sind, können dafür ebenfalls Lötfahnen oder -flächen aufgedruckt werden.

Mit der Erfindung werden bevorzugt mehr oder weniger harte Leiterplatten bedruckt, da bei jenen die aufgedruckten Leiterbahn-Strukturen keiner nennenswerten Biegebeanspruchung ausgesetzt sind und also keinem Verschleiß unterliegen.

Weitere Merkmale, Einzelheiten, Vorteile und Wirkungen auf der Basis der Erfindung ergeben sich aus der folgenden Beschreibung einer bevorzugten Ausführungsform der Erfindung sowie anhand der Zeichnung. Hierbei zeigt:
- Fig. 1: eine erfindungsgemäße Vorrichtung zur Herstellung von Leiterplatten für elektrische und elektronische Schaltungen in einer Seitenansicht, umfassend einen Thermo-Druckkopf; sowie
- Fig. 2: eine Ansicht auf die Unterseite des Thermo-Druckkopfs von Fig. 1 in Richtung der Pfeile II - II.

Im Rahmen der Erfindung wird für die Herstellung von Leiterplatten für elektrische und elektronische Schaltungen eine Vorrichtung 1 verwendet mit einem Druckkopf 2 zur selektiven, lokalen Erhitzung einzelner Druck-Spots oder -Pixels eines in flächiger Form vorliegenden, elektrisch leitfähigen Druckmediums 3, damit an den ausgewählten Druck-Spots oder -Pixel das Druckmedium geschmolzen wird und nach Übertragung auf ein darunter oder daneben befindliches Substrat 4 dort wieder in Form einer gemeinsamen Matrix erstarrt, wobei sich die gewünschten Leiterbahnen im Idealfall ohne Übergangswiderstände ergeben.

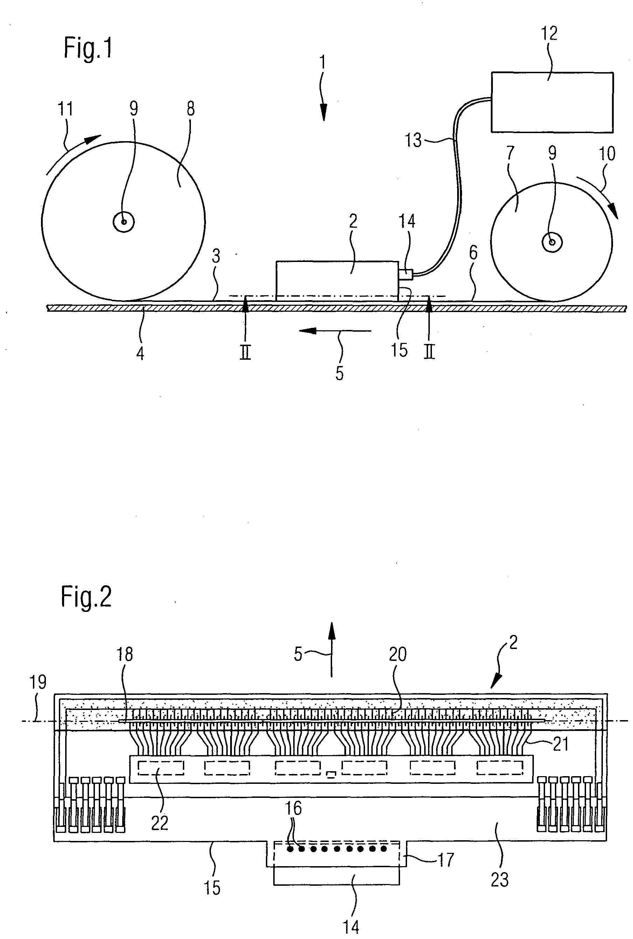

Nicht dargestellt ist in Fig. 1 eine Transportvorrichtung, um das zu bedruckende Leiterplatten-Substrat 4 gegenüber dem Druckkopf 2 in Bewegung 5 zu versetzen. Es kann sich dabei um eine Rollenbahn oder ein Fließband handeln, oder auch um eine schwingend bewegte Platte.

Ferner kann in Transportrichtung 5 gesehen vor dem Druckkopf eine Heizeinrichtung angeordnet sein, um das Leiterplatten-Substrat 4 vorzuwärmen, wodurch die von dem Thermo-Druckkopf 2 zu erzeugende Hitze reduziert wird. Es könnte sich hierbei um einen Temperaturstrahler handeln, an welchem das flächige, insbesondere plattenförmige Substrat 4 entlang bewegt wird. Andererseits genügt es auch, das Leiterplatten-Material 4 bspw. in einem Ofen vorzuwärmen, aus welchem es dann bspw. chargenweise mit der richtigen Temperatur entnommen werden kann.

Das Druckmedium 3 befindet sich an der dem Substrat 4 zugewandten Seite bzw. Fläche eines folienförmigen Trägermaterials 6, welches sich zwischen dem Druckkopf 2 und dem Substrat 4 erstreckt und dort synchron mit der Transportbewegung 5 transportiert werden kann.

Erfindungsgemäß hat das Trägermaterial 6 die Gestalt eines langen Bandes, welches von einer Vorratsspule 7 und einer Ablagespule 8 umgespult wird.

Hinsichtlich der Umspulgeschwindigkeit sollte ferner beachtet werden, dass diese möglichst vollkommen synchron zu der Transportbewegung 5 des Substrats 4 ist, so dass es also möglichst gar keine Relativbewegung zwischen den flächigen Elementen, nämlich dem Substrat 4 einerseits und dem Trägermaterial 6 andererseits, gibt. Dies setzt u.a. voraus, dass sich die Vorratsspule 7 im Hinblick auf die Transprortrichtung 5 des Substrats 4 stromaufwärts des Druckkopfes 2 befindet, während die Ablagespule 8 stromabwärts des Druckkopfes 2 angeordnet ist.

Die Achsen oder Wellen 9 der Vorratsspule 7 einerseits sowie der Ablagespule 8 andererseits können in einer Richtung lotrecht zu der Ebene des zu bedruckenden Substrats 4 anstellbar sein, so dass der Abschnitt der das Druckmedium 3 tragenden Trägerfolie 6 in dem Bereich des Druckkopfs 2 stets parallel zu dem Substrat 4 ausgerichtet ist, und vorzugsweise flächig an letzterem anliegt.

Wenn die Vorrats- und Ablagespulen 7, 8 reibschlüssig gegen das Substrat 4 gepresst werden, so wird durch diesen Reibschluß sichergestellt, dass die Umfangsgeschwindigkeit 10, 11 der Vorrats- und Ablagespule 7, 8 stets betragsmäßig gleich groß mit der Transportgeschwindigkeit 5 des Substrats 4, unabhängig von den aktuellen Durchmessern dieser beiden Spulen 7, 8, welche sich ja im Verlaufe des Umspulens von der Vorratsspule 7 zur Ablagespule 8 kontinuierlich ändert. Natürlich könnte eine solche Synchronität zwischen den Spulen-Umfangsgeschwindigkeiten 10, 11 einerseits und der Transportgeschwindigkeit 5 andererseits auch durch eine geeignete Steuerung oder Regeleung bewerkstelligt werden, was jedoch einen erhöhten Konstruktionsaufwand bedeutet. Denn im Gegensatz zu der ersten Ausführungsform, wo die Vorrats- und Ablagespule 7, 8 passiv angetrieben werden, ihren Antrieb also von dem zu bedruckenden Substrat 4 empfangen, müsste(n) in letzterem Fall auch (getrennte) Antriebe für beide Spulen 7, 8 vorgesehen werden.

Der Druckkopf 2 wird von einem Steuergerät 12 angesteuert, vorzugsweise gemäß einem dort gespeicherten Leiterbahnen-Layout. Das Steuergerät 12 kann über eine oder mehrere, vorzugsweise elektrische Steuerleitungen 13 mit dem Druckkopf 2 verbunden sein, welche bspw. über eine Steckeinrichtung 14 Kontakt zu dem Druckkopf 2 erhalten.

In Fig. 2 ist eine mögliche Ausführungsform des Druckkopfs 2 detaillierter zu sehen. Man erkennt an einer Seite, bspw. an einer stromaufwärtigen Stirnseite 15 des Druckkopfs 2, eine mit Steckkontakten 16 versehene Buchse 17 zum Einstecken des Stecker 14 von dem Steuergerät 12.

Die eigentliche Thermo-Heizeinrichtung 18 des Druckkopfs 2 erstreckt sich lotrecht zu der Transportrichtung 5 des Substrats 4, vorzugsweise entlang einer gerade gestreckten Linie 19. Es kann sich hierbei um einen gerade gestreckten Heizleiter 18 handeln, aus einem stark widerstandsbehafteten Material, bspw. aus Wolfram, woraus auch die Heizdrähte von Glühbirnen bestehen.

Von diesem Heizleiter 18 zweigen eine große Anzahl von Zuleitungen 20, 21 ab, vorzugsweise abwechselnd jeweils in Transportrichtung 5 und entgegen derselben.

Jede zweite dieser Zuleitungen 20, vorzugsweise diejenigen, welche in der der Steckbuchse 17 gegenüber liegenden Richtung 5 abzweigen, sind untereinander verbunden und dadurch kurzgeschlossen und mit einem gemeinsamen Kontakt 16 verbunden, vorzugsweise mit einem dortigen MasseKontakt.

Die übrigen Zuleitungen 21, welche vorzugsweise in der Richtung zu der Steckbuchse 17 hin von dem heizleiter 18 abzweigen, also vorzugsweise entgegen der Transportrichtung 5, sind über je einen Halbleiterschalter 22 an eine Spannungsversorgung angeschlossen, insbesondere an einen Kontaktstift 16 mit einer Versorgungsspannung.

Über einen Leitungsbus als Bestandteil der Zuleitung 13 und die entsprechenden Steckkontakte lassen sich die einzelnen Halbleiterschalter 22 addresseiren, um jene selektiv auf EIN zu schalten, falls der einem Halbleiterschalter 22 zugeordnete Abschnitt des Heizleiters 18 erhitzt werden soll, um an der betreffenden Stelle einen Pixel zu drucken.

Vorzugsweise besteht das Chassis 23 des Druckkopfs 2 aus Keramik oder einem anderen, für hohe Temperaturen geeigneten Material. Die Schmelz- oder Erweichungstemperatur dieses Materials sollte insbesondere höher sein als die maximale Betriebstemperatur des Heizleiters 18.

Insbesondere wenn das Substrat 4 mittels einer nicht dargestellten Heizeinrichtung oder in einem Ofen auf eine Temperatur knapp unterhalb der Betreibstemperatur des Heizleiters 18 vorgewärmt wird, muss innerhalb des Druckkopfs nur eine geringe Energie zugeführt werden, damit infolge der zusätzlichen Wärmemenge die Temperatur des betreffenden Abschnitts des Heizdrahtes 8 auf die gewünschte Betriebstemperatur steigt.

Natürlich wäre es grundsätzlich auch möglich, anstelle eines Heizdrahtes 18 andere Energiewandler zu verwenden, um die benötigte Wärmemenge auf einen zu bedruckenden Spot des Substrats 4 zu fokussieren. Eine demgegenüber große Energiemenge könnte bspw. mittels eines Lasers erzeugt werden, sofern dessen Laserstrahl je nach dem gewünschten Leiterbahn-Layout zu den betreffenden Spots gelenkt und dort auf das Trägermaterial 6 oder vorzugsweise durch dieses hindurch unmittelbar in das Druckmedium 3 gerichtet wird.

Dies könnte bspw. mittels einer Vielzahl von Lichtleitern erfolgen, welche einseitig mit dem Laser gekoppelt werden und deren jeweils freie Enden je einem Pixel bzw. Spot zugeordnet werden. Indem mittels Licht-Schaltern der Lichtstrom zwischen Laser und Lichtleiter dem gewünschten Leiterbahn-Layout entsprechend gesteuert wird, können selektiv einzelne Pixel bzw. Spots erhitzt werden.

Eine optimale Energieausbeute bzw. Effektivität erhält man, wenn ein Laser im roten und/oder infraroten Spektrum verwendet wird, so dass die Strahlungsleistung überwiegend oder ausschließlich als Wärmestrahlung abgegeben wird.

Besonders geeignet erscheinen auch sogenannte Faserlaser, eine spezielle Form von Festkörperlasern. Als aktives Medium dient dabei ein dotierter Kern einer Glasfaser, so dass ein Faserlaser also ein Glaslaser ist, mit Eigenschaften eines Lichtwellenleiters. Die Laserstrahlung wird durch die laseraktive Faser geleitet und erfährt dabei aufgrund der vergleichsweise großen Länge eine sehr hohe Verstärkung.

Faserlaser sind im Allgemeinen optisch gepumpt, indem parallel zum Faserkern in dessen Mantel oder in den Faserkern selbst Strahlung wenigstens eines Diodenlasers eingekoppelt wird. Eine Struktur mit sogenannten Doppelmantelfasern liefert eine höhere Leistungsausbeute, wobei die Pumpstrahlung aus dem dicken Mantel verteilt in den aktiven Faserkern gelangt.

Als Dotierungselemente für den laseraktiven Faserkern können Erbium, Ytterbium und/oder Neodym dienen. Meist erhält nur der Mittelteil der Glasfaser eine Dotierung.

Faserlaser haben elektro-optische Wirkungsgrade bis über 30 %, ferner eine herausragende Strahlqualität, eine hohe Lebensdauer und einen kompakten, wartungsfreien und unempfindlichen Aufbau. Im Pulsbetrieb lassen sich mit Faserlasern hohe Spitzenintensitäten erreichen, mithin eine hohe Leistungsdichte, um punktuell Temperaturen oberhalb des Schmelzpunktes T_{S} von Metallen wie Silber (T_{S} = 961 °C) oder Kupfer (T_{S} = 1.085 °C) zu erzeugen. Daher können mit dieser Technik selbst durchgängige Leiterbahnen aus Kupfer hergestellt werden.

Bei Bedarf können mehrere Druckeinrichtungen mit je einerm Druckkopf 2 und je einer Vorrats- und Ablagespule 7, 8 in Transportrichtung 5 des band- oder folienförmigen Trägermaterials 6 hintereinander angeordnet sein, um mehrere Schichten von elektrisch leitenden und elektrisch nicht leitenden Strukturen übereinander zu drucken, ggf. auch Strukturen aus speziellen Materialien wie Dielektrika, bspw. für die Herstellung eines Schicht-Kondensators. Jedoch sollte bei übereinander zu druckenden Schichten darauf geachtet werden, dass bereits applizierte Strukturen nicht wieder geschmolzen werden, wodurch dann unerwünschte Kurzschlüsse zwischen verschiedenen Schichten entstehen könnten. Deshalb empfiehlt es sich, die Anzahl übereinander zu druckender Schichten zu begrenzen und lieber mehrere, jeweils entsprechend fertig bedruckte Substrat-Schichten 4 aneinander zu laminieren.

### Bezugszeichenliste

- 1: Vorrichtung
- 2: Druckkopf
- 3: Druckmedium
- 4: Substrat
- 5: Transportbewegung
- 6: Trägermaterial
- 7: Vorratsspule
- 8: Ablagespule
- 9: Achse, Welle
- 10: Umfangsgeschwindigkeit
- 11: Umfangsgeschwindigkeit
- 12: Steuergerät
- 13: Steuerleitung
- 14: Steckeinrichtung
- 15: stromaufwärtige Stirnseite
- 16: Steckkontakte
- 17: Buchse
- 18: Heizleiter
- 19: gerade Linie
- 20: Zuleitung
- 21: Zuleitung
- 22: Halbleiterschalter
- 23: Chassis

## Patentansprüche

1. Verfahren zur Herstellung von Leiterplatten für elektrische und elektronische Schaltungen, mit einem elektrisch nicht leitenden Substrat (4) und darauf applizierten, elektrisch leitenden Bahnen, wobei die elektrisch leitenden Bahnen entsprechend dem gewünschten Leiterbahn-Layout unter Einwirkung von Hitze auf ein elektrisch leitfähiges Druckmedium (3) auf das Substrat (4) aufgedruckt werden, wobei das Druckmedium (3) als elektrisch leitfähigen Bestandteil ein Metall oder eine Metalllegierung aufweist, das/die eine für das Metall oder die Metalllegierung typische Schmelztemperatur aufweist und von einem Druckkopf (2) an ausgewählten Druck-Spots oder -Pixels selektiv lokal erhitzt wird, wobei der metallische, leitfähige Bestandteil des Druckmediums (3)
- lokal bis auf die typische Schmelztemperatur des Metalls oder der Metalllegierung erhitzt und dadurch geschmolzen wird, und
- auf dem Substrat (4) in Form einer gemeinsamen Matrix erstarrt;
wobei das Druckmedium (3) auf einem folienartigen Träger (6) appliziert ist, **dadurch gekennzeichnet, dass** der folienartige Träger (6)
- eine Carbonfolie oder ein Glasfilm ist, und
- von einer Vorratsspule (7) entlang des zu bedruckenden Substrats (4) auf eine Ablagespule (8) umgespult wird.

2. Verfahren nach Anspruch 1, **dadurch gekennzeichnet, dass** das elektrisch leitfähige Druckmedium (3) mittels eines Thermo-Druckkopfs (2) erhitzt wird.

3. Verfahren nach Anspruch 1 oder 2, **dadurch gekennzeichnet, dass** wenigstens eine elektrisch nicht leitende Schicht in Form eines elektrisch nicht leitenden Druckmediums (3) auf das Substrat (4) aufgedruckt wird, vorzugsweise unter Hitzeeinwirkung auf das nicht leitende Druckmedium (3).

4. Verfahren nach einem der Ansprüche 1 bis 3, **dadurch gekennzeichnet, dass** elektrische oder elektronische Bauteile ebenfalls auf das Substrat (4) aufgedruckt werden, beispielsweise Widerstände, Spannungsteiler, etc. mittels eines widerstandsbehafteten Druckmediums (3), Kondensatoren durch Aufeinanderschichten einer unteren Schicht aus einem elektrisch leitenden Druckmedium (3), einer mittleren Schicht aus einem nicht leitenden Druckmedium (3), und einer oberen Schicht aus einem elektrisch leitenden Druckmedium (3), etc.

5. Vorrichtung (1) zur Herstellung von Leiterplatten für elektrische und elektronische Schaltungen, mit einem elektrisch nicht leitenden Substrat (4) und darauf applizierten, elektrisch leitenden Bahnen, umfassend
- eine Vorratsspule mit einem folienartigen Träger, wobei ein elektrisch leitfähiges Druckmedium (3) auf dem folienartigen Träger (6) appliziert ist, und wobei der folienartige Träger (6) von der Vorratsspule (7) entlang eines zu bedruckenden Substrats (4) auf eine Ablagespule (8) umgespult werden kann, und
- einen Druckkopf (2) zur selektiven Erhitzung des Druckmediums (3) entsprechend dem gewünschten Leiterbahn-Layout, um dieses Druckmedium (3) auf das Substrat (4) zu übertragen, wobei das Druckmedium (3) als elektrisch leitfähigen Bestandteil ein Metall oder eine Metalllegierung aufweist, das/die eine für das Metall oder die Metalllegierung typische Schmelztemperatur aufweist und von einem Druckkopf (2) an ausgewählten Druck-Spots oder - Pixels selektiv lokal erhitzt werden kann,
wobei der Druckkopf (2) derart ausgebildet ist, dass der metallische, leitfähige Bestandteil des Druckmediums (3)
- lokal bis auf die typische Schmelztemperatur des Metalls oder der Metalllegierung erhitzt und dadurch geschmolzen werden kann, und
- auf dem Substrat (4) in Form einer gemeinsamen Matrix erstarren kann,
und wobei der folienartige Träger eine Carbonfolie oder ein Glasfilm ist.

6. Vorrichtung (1) nach Anspruch 5, **dadurch gekennzeichnet, dass** der Druckkopf (2) wenigstens eine Heizeinrichtung aufweist, vorzugsweise einen Heizleiter (18) mit einer größeren Anzahl von einzelnen Abschnitten, welche selektiv mit Strom bzw. Spannung versorgt werden können, um an dem betreffenden Spot Wärme zu induzieren und dadurch dort einen Pixel zu drucken.

7. Vorrichtung (1) nach Anspruch 5 oder 6, **dadurch gekennzeichnet, dass** der Druckkopf (2) wenigstens eine Heizeinrichtung aufweist, vorzugsweise einen Laser, mit einer größeren Anzahl von einzelnen Lichtleiter-Abschnitten, welche an jeweils unterschiedlichen Spots enden und selektiv mit dem Strahl des Lasers angesteuert werden können, um an dem betreffenden Spot Wärme zu induzieren und dadurch dort einen Pixel zu drucken.

8. Vorrichtung (1) nach einem der Ansprüche 5 bis 7, **gekennzeichnet durch** eine Transporteinrichtung, um das Substrat (4) relativ zu dem Druckkopf (2) zu bewegen (Bewegung 5).

9. Vorrichtung (1) nach Anspruch 8, **dadurch gekennzeichnet, dass** die Transportgeschwindigkeit des folienartigen Trägers (6) in dem Bereich zwischen Vorratsspule (7) und Ablagespule (8) gleich der Tansportgeschwindigkeit (5) des zu bedruckenden Substrats (4) ist.

10. Vorrichtung (1) nach einem der Ansprüche 5 bis 9, **gekennzeichnet durch** mehrere Druckeinrichtungen mit je einem Thermo-Druckkopf (2) und je einer Vorrats- und Ablagespule (7,8) für je ein band- oder folienförmiges, mit einem Druckmedium (3) versehenes Trägermaterial (6), welche Druckeinrichtungen in Transportrichtung (5) des zu bedruckenden Substrats (4) hintereinander angeordnet sind.

## Claims

1. A method for manufacturing printed circuit boards for electrical and electronic circuits, comprising an electrically nonconductive substrate (4) and electrically conductive tracks applied thereon, wherein the electrically conductive tracks are imprinted on the substrate (4) according to the desired conductor track layout, under the influence of heat on an electrically conductive printing medium (3), wherein the printing medium (3) comprises as electrically conductive ingredient a metal or a metal alloy, which has a melting temperature typical for the metal or the metal alloy and is selectively heated by a printing head (2) at selected printing spots or pixels, wherein the metallic, conductive ingredient of the printing medium (3)
- is locally heated up to the typical melting temperature of the metal or the metal alloy and is melted thereby, and
- solidifys on the substrate (4) in the form of a common matrix,
and wherein the printing medium (3) is applied to a film-like carrier (6), **charactericed in that** the film-like carrier (6)
- is a carbon foil or a glass film, and
- is wound from a supply spool (7), along the substrate (4) to be imprinted, onto a laydown spool (8).

2. The method according to Claim 1, **characterized in that** the electrically conductive printing medium (3) is heated by means of a thermal print head (2).

3. The method according to Claim 1 or 2, **characterized in that** at least one electrically nonconductive layer in the form of an electrically nonconductive printing medium (3) is imprinted on the substrate (4), preferably under the influence of heat on the printing medium (3).

4. The method according to one of Claims 1 to 3, **characterized in that** electrical or electronic components are likewise imprinted on the substrate (4), for example resistors, voltage dividers, etc., by means of a resistive printing medium (3), capacitors by providing, one on top of the other, a bottom layer made of an electrically conductive printing medium (3), a middle layer made of a nonconductive printing medium (3), and a top layer made of an electrically conductive printing medium (3), etc.

5. A device (1) for manufacturing printed circuit boards for electrical and electronic circuits, comprising an electrically nonconductive substrate (4) and electrically conductive tracks applied thereon, the device comprising:
- a supply spool (7) with a foil-like carrier, wherein an electrically condictive printing medium (3) is applied to the foil-like carrier (6), and wherein the foil-like carrier (6) can be wound from supply spool (7), along a substrate (4) to be imprinted, onto a laydown spool (8), and
- a print head (2) for selectively heating an electrically conductive printing medium (3) according to the desired conductor track layout, in order to transfer this printing medium (3) onto the substrate (4), wherein the printing medium (3) comprises as electrically conductive ingredient a metal or a metal alloy, which has a melting temperature typical for the metal or the metal alloy and can be heated selectively by a printing head (2) at selected printing spots or pixels,
wherein the print head (2) is formed in such a way that the metallic, conducting ingredient of the printing medium (3)
- is locally heated up to the typical melting temperature of the metal or the metal alloy and is melted thereby, and
- solidifys on the substrate (4) in the form of a common matrix,
and wherein the foil-like carrier is a carbon foil or a glass film.

6. The device (1) according to Claim 5, **characterized in that** the print head (2) has at least one heating device, preferably a heating conductor (18) having a fairly large number of individual sections that can be selectively supplied with current or voltage in order to induce heat at the spot in question and thus print a pixel at that location.

7. The device (1) according to Claim 5 or 6, **characterized in that** the print head (2) has at least one heating device, preferably a laser, having a fairly large number of individual optical fiber sections which in each case end at different spots and may be selectively excited with the beam of the laser in order to induce heat at the spot in question and thus print a pixel at that location.

8. The device (1) according to one of Claims 5 to 7, **characterized by** a transport device for moving the substrate (4) relative to the print head (2) (movement (5)).

9. The device (1) according to Claim 8, **characterized in that** the transport speed of the film-like carrier (6) in the area between the supply spool (7) and the laydown spool (8) is equal to the transport speed (5) of the substrate (4) to be imprinted.

10. The device (1) according to one of Claims 5 to 9, **characterized by** multiple printing devices, each having a thermal print head (2) and a supply spool as well as a laydown spool (7, 8) for a strip- or film-like carrier material (6) each provided with a printing medium (3), the printing devices being arranged in succession in the transport direction (5) of the substrate (4) to be imprinted.

## Revendications

1. Procédé de fabrication de cartes de circuits imprimés pour des circuits électriques et électroniques, avec un substrat (4) électriquement non conducteur et des pistes électriquement conductrices qui y sont appliquées, en ce que les pistes électriquement conductrices conformément à la topologie de pistes conductrices souhaitée sont imprimées sur le substrat (4) sous l'action de la chaleur sur un support d'impression (3) électriquement conducteur, en ce que le support d'impression (3) en tant que composant électriquement conducteur comporte un métal ou un alliage métallique qui présente une température de fusion caractéristique pour le métal ou l'alliage métallique et qui est sélectivement mis en température localement par une tête d'impression (2) sur des points ou des pixels d'impression sélectionnés, le composant métallique conducteur du support d'impression (3)
- étant chauffé localement jusqu'à la température de fusion caractéristique du métal ou de l'alliage métallique et ainsi fondu, et
- se solidifiant sur le substrat (4) sous la forme d'une matrice commune ; en ce que le support d'impression (3) est appliqué sur un support de type feuille (6), **caractérisé en ce que** le support de type feuille (6)
- est une feuille de carbone ou un film de verre, et
- est rebobiné d'une bobine de chargement (7) sur une bobine de réception (8) le long du substrat (4) à imprimer.

2. Procédé selon la revendication 1, **caractérisé en ce que** le support d'impression (3) électriquement conducteur est chauffé au moyen d'une tête d'impression (2) thermique.

3. Procédé selon la revendication 1 ou 2, **caractérisé en ce qu'**au moins une couche électriquement non conductrice sous forme de support d'impression (3) électriquement non conducteur est imprimée sur le substrat (4), de préférence sous l'action de la chaleur sur le support d'impression (3) non conducteur.

4. Procédé selon l'une des revendications 1 à 3, **caractérisé en ce que** des composants électriques ou électroniques sont également imprimés sur le substrat (4), par exemple des résistances, des diviseurs de tension, etc. au moyen d'un support d'impression (3) résistif, de condensateurs par superposition d'une couche inférieure constituée d'un support d'impression (3) électriquement conducteur, d'une couche moyenne constituée d'un support d'impression (3) non conducteur, et d'une couche supérieure constituée d'un support d'impression (3) électriquement conducteur, etc.

5. Dispositif (1) de fabrication de cartes de circuits imprimés pour des circuits électriques et électroniques, avec un substrat (4) électriquement non conducteur et des pistes électriquement conductrices qui y sont appliquées, comportant
- une bobine de chargement avec un support de type feuille, en ce qu'un support d'impression (3) électriquement conducteur est appliqué sur le support de type feuille (6), et en ce que le support de type feuille (6) peut être rebobiné de la bobine de chargement (7) le long d'un substrat (4) à imprimer sur une bobine de réception (8), et
- une tête d'impression (2) destinée à la mise en chauffe sélective du support d'impression (3) conformément à la topologie de pistes conductrices souhaitée pour transférer ce support d'impression (3) sur le substrat (4), en ce que le support d'impression (3) en tant que composant électriquement conducteur comporte un métal ou un alliage métallique qui présente une température de fusion caractéristique pour le métal ou l'alliage métallique et qui peut être sélectivement chauffé localement par une tête d'impression (2) sur des points ou des pixels d'impression sélectionnés, en ce que la tête d'impression (2) est telle que le composant métallique conducteur du support d'impression (3)
- est chauffé localement à la température de fusion caractéristique du métal ou de l'alliage métallique et qu'il peut ainsi être fondu, et
- peut se solidifier sur le substrat (4) sous forme d'une matrice commune, et en ce que le support de type feuille est une feuille de carbone ou un film de verre.

6. Dispositif (1) selon la revendication 5, **caractérisé en ce que** la tête d'impression (2) comporte au moins un dispositif de chauffage, de préférence un conducteur chauffant (18) ayant un grand nombre de sections individuelles, qui peuvent être alimentées sélectivement en courant ou en tension pour induire de la chaleur au niveau du point correspondant et d'y imprimer ainsi un pixel.

7. Dispositif (1) selon la revendication 5 ou 6, **caractérisé en ce que** la tête d'impression (2) comporte au moins un dispositif de chauffage, de préférence un laser, ayant un grand nombre de sections de fibres optiques individuelles qui se terminent respectivement à des points différents et qui peuvent être activés sélectivement avec le rayon du laser pour induire de la chaleur au niveau du point correspondant et d'y imprimer ainsi un pixel.

8. Dispositif (1) selon l'une des revendications 5 à 7, **caractérisé par** un dispositif de transport pour déplacer le substrat (4) par rapport à la tête d'impression (2) (déplacement 5).

9. Dispositif (1) selon la revendication 8, **caractérisé en ce que** la vitesse de transport du support de type feuille (6) dans la zone entre la bobine de chargement (7) et la bobine de réception (8) est égale à la vitesse de transport (5) du substrat (4) à imprimer.

10. Dispositif (1) selon l'une des revendications 5 à 9, **caractérisé par** plusieurs dispositifs d'impression ayant chacun une tête d'impression (2) thermique et chacun une bobine de chargement et de réception (7, 8) pour chaque matériau de support (6) en forme de bande ou de feuille, pourvu d'un support d'impression (3), lesquels dispositifs d'impression sont disposés successivement dans le sens de transport (5) du substrat (4) à imprimer.
